# EUROPEAN PATENT SPECIFICATION

(11) **EP 4 080 868 B1**
(45) Date of publication and mention of the grant of the patent: **14.05.2025**
(21) Application number: 19956844.5
(22) Date of filing: 17.12.2019
(51) Int. Cl.: G03B 15/05, H04N 17/00, H05K 13/08, H04N 23/56, H04N 23/57, H04N 23/74

(54) **WORK MACHINE**
ARBEITSMASCHINE
MACHINE DE TRAVAIL

(43) Date of publication of application: 26.10.2022
(73) Proprietor: Fuji Corporation, Chiryu-shi, Aichi 472-8686 (JP)
(72) Inventor: KONDO, Daigo, Chiryu-shi, Aichi 472-8686 (JP)
(74) Representative: Grünecker Patent- und Rechtsanwälte PartG mbB
(86) International application number: PCT/JP2019/049403
(87) International publication number: WO 2021/124447

(56) References cited:
- EP-A1- 1 592 233
- EP-A1- 2 432 227
- WO-A1-2019/111331
- WO-A1-2019/111331
- JP-A- 2007 003 323
- JP-A- 2012 070 046
- JP-A- 2012 198 076
- JP-A- 2012 506 060

## Description

### Technical Field

The present disclosure relates to a work machine that mounts electronic components on a circuit base material.

### Background Art

Patent Literature 1 discloses an imaging unit in which an appropriate value of resolution for light of one or more light sources selected from multiple light sources used for imaging is obtained, light of one or more light sources is applied to a subject held by a holding member to image the subject with a camera, and the appropriate value of the resolution is used for processing an image obtained through the imaging.
Patent Application JP 2007/003323 A relates to a photographic system for capturing images of a subject being arranged in a casing. A photographic apparatus includes a housing for housing a subject and a photographing unit capturing the image of the subject. The subject is placed on a placement surface held by the subject moving unit. A drive unit moves the placement surface in the Z direction. A light source includes a bottom light source and an epi light source that irradiate light of different wavelengths on the subject. A controller controls the photographing unit to capture an image of the subject at a first wavelength and a second wavelength that is different from the first wavelength. Before image capture, a user operates the subject moving unit so as to determine a photographing distance SD. At least one image sensor and the subject are moved in the optical axis direction to correct for the lateral chromatic aberration of imaging lens. A storage means stores a table in which the relationship between the chromatic aberration of magnification and the optimum difference in image distance at each wavelength is stored.
Patent Application EP 2 432 227 A1 relates to aberration correction to correct chromatic aberration of magnification, based on stored correction data associated with correction levels and on predetermined combinations of aberration variation conditions.
Patent Application EP 1 592 233 A1 relates to image recording and reproduction, and in particular to chromatic aberration correction of an aperture amount of an iris and a lens image height of an object in an image pickup lens.

### Patent Literature

Patent Literature 1: International Publication No. WO 2019/111331 A1

### Summary of the Invention

### Technical Problem

However, in the imaging unit disclosed in Patent Literature 1, since the above appropriate value of the resolution is acquired by using an off-line imaging device different from a component mounter to which the imaging unit is attached, efforts and cost of manufacturing the off-line imaging device are increased.

Therefore, an object of the present disclosure is to provide a work machine capable of correcting chromatic aberration included in an image obtained by imaging a component without using a device separate from the work machine.

### Solution to Problem

The present invention is defined by the features of the independent claim, with preferred embodiments being specified in the dependent claims. References to embodiments which do not fall under the scope of the claims are to be understood as examples useful for understanding the invention.

### Advantageous Effect of the Invention

According to the present disclosure, it is possible to correct chromatic aberration included in an image obtained by imaging a component without using a device separate from a work machine.

### Brief Description of Drawings

Fig. 1 is a perspective view illustrating a component mounter.
Fig. 2 is a perspective view illustrating a component attachment device of the component mounter.
Fig. 3 is a schematic diagram illustrating a part camera.
Fig. 4 is a block diagram illustrating a control device provided in a component mounter.
Fig. 5 is a diagram for describing an axial chromatic aberration ((a)) and a magnification chromatic aberration ((b)).
Fig. 6 is a diagram illustrating a lower surface ((a)) of a head and a captured image ((b)) of the lower surface.
Fig. 7 is a flowchart illustrating a procedure of a calibration process executed by a controller included in the control device in Fig. 4.

### Description of Embodiments

Embodiments of the present disclosure will be described in detail below with reference to the accompanying drawings.

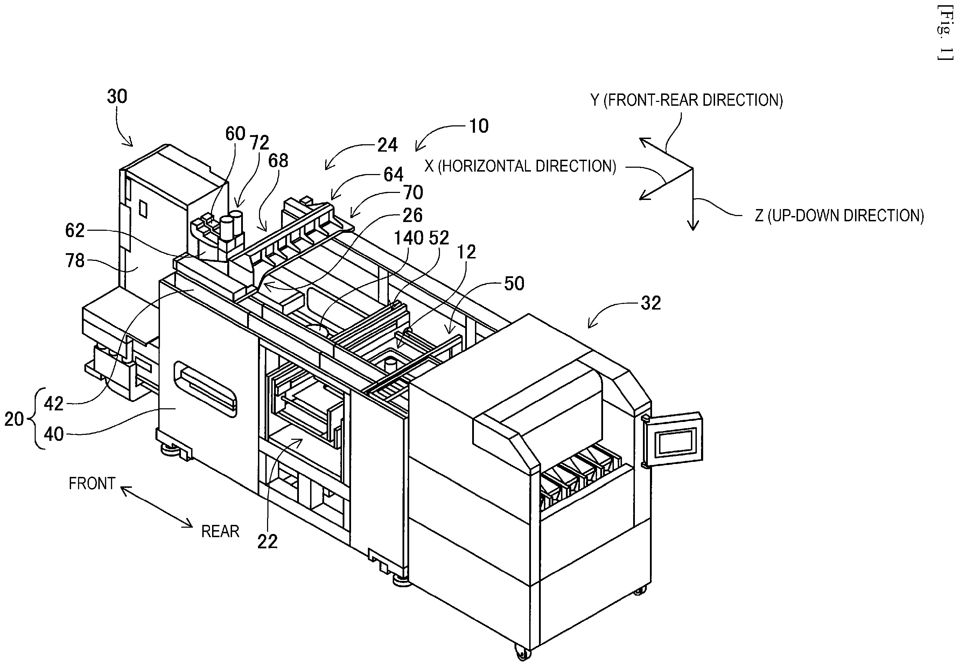

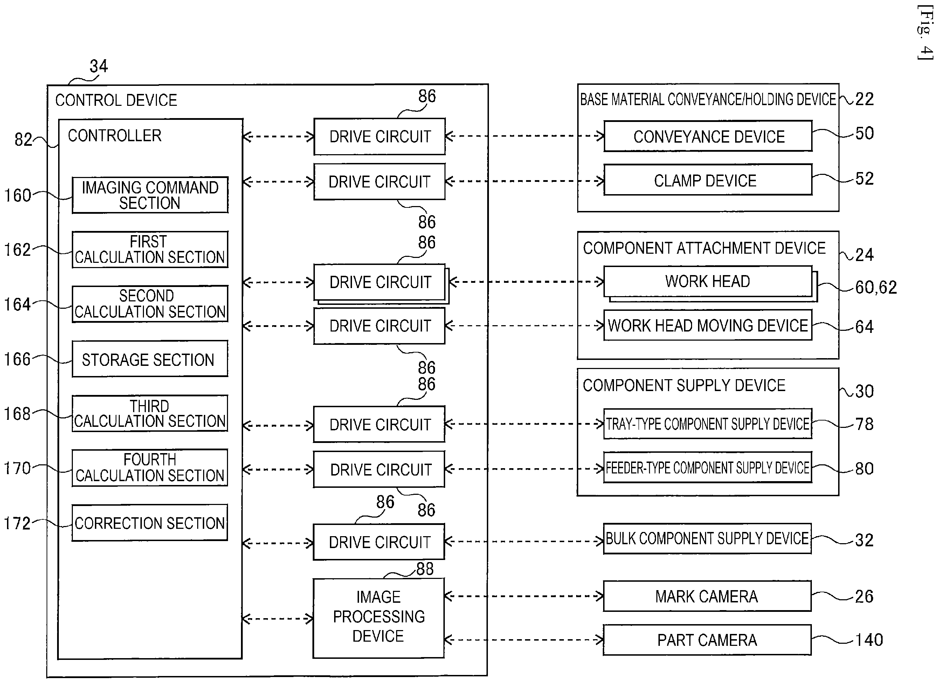

Fig. 1 illustrates component mounter 10 according to an embodiment of the present disclosure. Component mounter 10 is a device that executes component mounting work on circuit base material 12. Component mounter 10 includes device main body 20, base material conveyance/holding device 22, component attachment device 24, mark camera 26, part camera 140, component supply device 30, bulk component supply device 32, and control device 34 (refer to Fig. 4). Examples of circuit base material 12 include a circuit board and a base material having a three-dimensional structure, and examples of the circuit board include a printed wiring board and a printed circuit board.

Device main body 20 includes frame portion 40 and beam portion 42 that is suspended on frame portion 40. Base material conveyance/holding device 22 is disposed at the center of frame portion 40 in the front-rear direction, and has conveyance device 50 and clamp device 52. Conveyance device 50 is a device that conveys circuit base material 12, and clamp device 52 is a device that holds circuit base material 12. Consequently, base material conveyance/holding device 22 conveys circuit base material 12 and holds circuit base material 12 fixedly at a predetermined position.

In the description below, a conveyance direction of circuit base material 12 will be referred to as an X direction, a horizontal direction perpendicular to that direction will be referred to as a Y direction, and a vertical direction will be referred to as a Z direction. That is, a width direction of component mounter 10 is the X direction, and a front-rear direction is the Y direction.

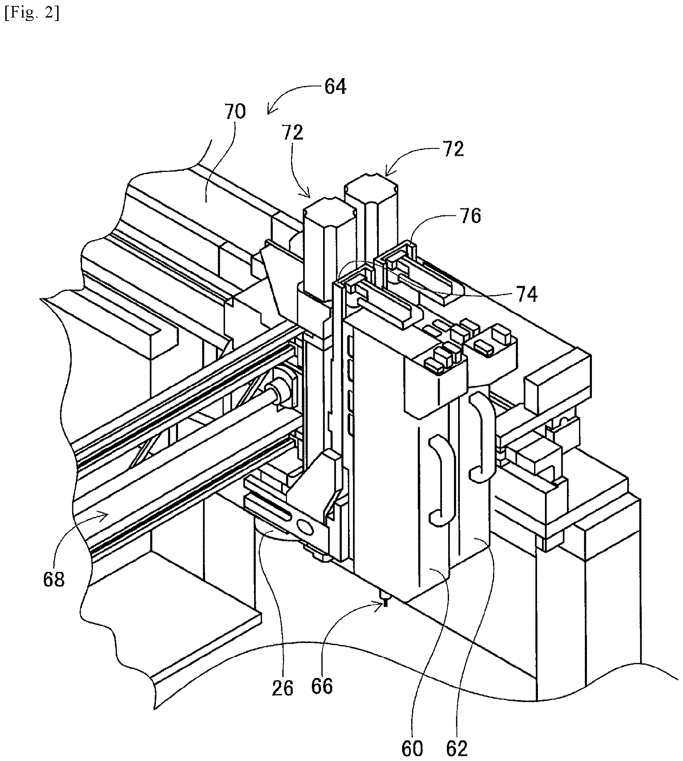

Component attachment device 24 is disposed in beam portion 42 and includes two work heads 60 and 62 and work head moving device 64. As illustrated in Fig. 2, suction nozzle 66 is provided on lower end face of each of work heads 60 and 62, and suction nozzle 66 picks up and holds a component.

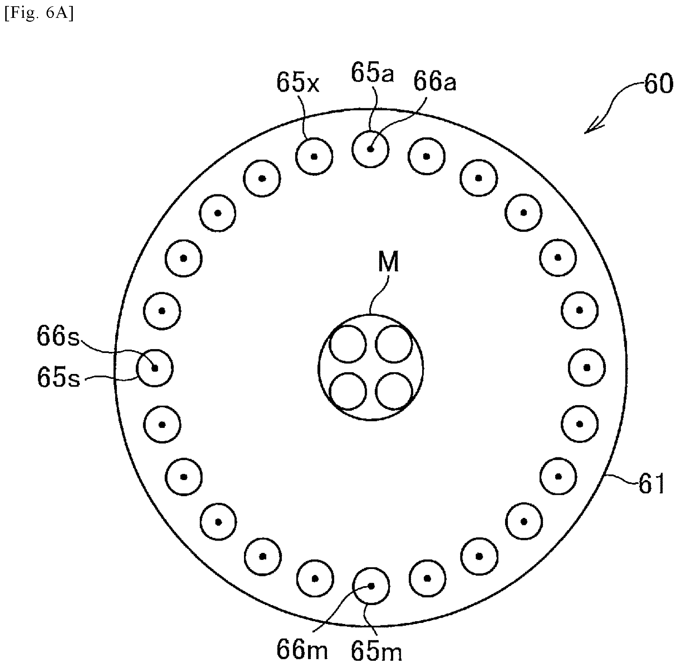

Fig. 6(a) is a view in which a lower end face of one work head, for example, work head 60 is viewed from the lower direction toward the upper direction. Lower end face 61 of work head 60 is formed in a disk shape as illustrated in Fig. 6(a), and twenty-four holders 65a to 65x are disposed at equal intervals on an outer circumferential part thereof. Each of holders 65a to 65x holds one suction nozzle 66. Respective holders 65 are denoted by the reference signs 65a to 65x in the clockwise direction from the first holder to the twenty-fourth holder. Similarly, each suction nozzle 66 is also denoted by the reference signs 66a to 66x in the clockwise direction from the first nozzle to the twenty-fourth nozzle. However, in Fig. 6(a), the reference signs of holders 65 and suction nozzle 66 are explicitly indicated only as necessary for describing the present embodiment.

Entire lower end face 61 and each suction nozzle 66 each are configured to be rotated by a rotation device using a motor (not illustrated) as a driving source, and thus a position of a picked up and held component on the outer circumferential part and a direction at that position can be changed.

Reference mark M is attached to the center of lower end face 61. Reference mark M is formed by a circle including four small circles. A method of using reference mark M will be described later.

Work head moving device 64 includes X-direction moving device 68, Y-direction moving device 70, and Z-direction moving device 72. Two work heads 60 and 62 can be integrally moved to any position on frame portion 40 by X-direction moving device 68 and Y-direction moving device 70. Work heads 60 and 62 are detachably attached to sliders 74 and 76, and Z-direction moving device 72 individually moves sliders 74 and 76 in the up-down direction. That is, work heads 60 and 62 can be individually moved in the up-down direction by Z-direction moving device 72.

Mark camera 26 is attached to slider 74 so as to face downward, and can be moved in the X direction, the Y direction, and the Z direction together with work head 60. Consequently, mark camera 26 images any position on frame portion 40. As illustrated in Fig. 1, part camera 140 is disposed to face upward between base material conveyance/holding device 22 and component supply device 30 on frame portion 40. Consequently, part camera 140 images components held by suction nozzles 66 of work heads 60 and 62.

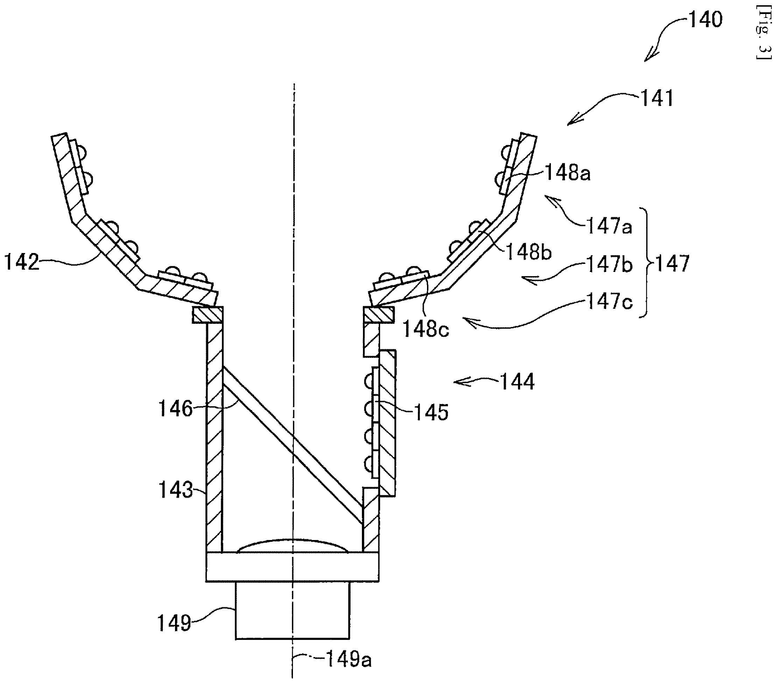

Specifically, as illustrated in Fig. 3, part camera 140 includes lighting section 141 and imaging section 149. Part camera 140 has an imaging range above part camera 140, and captures an image of a component held by suction nozzles 66a to 66x from below to generate a captured image.

Lighting section 141 irradiates a component that is an imaging target with light. Lighting section 141 includes housing 142, connecting portion 143, epi-illuminating light source 144, half mirror 146, and multi-stage light source 147.

Housing 142 is a bowl-shaped member of which upper and lower surfaces (bottom surfaces) are open in an octagonal shape. Housing 142 has a shape in which an opening on the upper surface is larger than an opening on the lower surface, and thus an internal space thereof tends to increase from the lower surface to the upper surface.

Connecting portion 143 is a cylindrical member that connects housing 142 to imaging section 149.

Epi-illuminating light source 144 includes multiple LEDs 145.

Half mirror 146 reflects light in the horizontal direction from LED 145 of epi-illuminating light source 144 upward. Half mirror 146 transmits light from the upper side toward imaging section 149.

Multi-stage light source 147 includes upper-stage light source 147a, middle-stage light source 147b, and lower-stage light source 147c. Upper-stage light source 147a includes multiple LEDs 148a, middle-stage light source 147b includes multiple LEDs 148b, and lower-stage light source 147c includes multiple LEDs 148c. Each of LEDs 148a to 148c applies light in a direction inclined from optical axis 149a. An inclined angle of an irradiation direction of LEDs 148a to 148c with respect to optical axis 149a is maximum in LED 148a, and thus LED 148a applies light in a substantially horizontal direction. The inclined angle of LED 148c is smallest. Upper-stage light source 147a is referred to as a side illuminating light source because the light source applies light in a substantially horizontal direction, and middle-stage light source 147b is referred to as an inclined light source because the light source applies light in an obliquely up direction.

In the present embodiment, LED 148a of upper-stage light source 147a is a blue LED, and LED 148b of middle-stage light source 147b, LED 148c of lower-stage light source 147c, and LED 145 of epi-illuminating light source 144 are red LEDs.

Imaging section 149 generates a captured image based on the received light. Imaging section 149 includes an optical system such as a lens (not illustrated) and an imaging element (for example, a charge coupled device (CCD)).

When light emitted from epi-illuminating light source 144 and multi-stage light source 147 after being reflected by an imaging target component passes through half mirror 146 and reaches imaging section 149, imaging section 149 receives the light to generate a captured image.

Component supply device 30 is disposed at a first end part of frame portion 40 in the front-rear direction. Component supply device 30 includes tray-type component supply device 78 and feeder-type component supply device 80 (refer to Fig. 4). Tray-type component supply device 78 is a device that supplies a component in a state in which the component is placed on a tray. Feeder-type component supply device 80 is a device that supplies a component by using a tape feeder or a stick feeder (not illustrated).

Bulk component supply device 32 is disposed at a second end part of frame portion 40 in the front-rear direction. Bulk component supply device 32 is a device that aligns multiple components in a scattered state and supplies the components in an aligned state. That is, bulk component supply device 32 is a device that aligns multiple components in any posture and supplies the components in a predetermined posture. Electronic circuit components, solar cell constituent components, and power module constituent components, are examples of components that are supplied by component supply device 30 and bulk component supply device 32. The electronic circuit components include a component having a lead, a component having no lead, and the like.

As illustrated in Fig. 4, control device 34 includes controller 82, multiple drive circuits 86, and image processing device 88. Multiple drive circuits 86 are connected to conveyance device 50, clamp device 52, work heads 60 and 62, work head moving device 64, tray-type component supply device 78, feeder-type component supply device 80, and bulk component supply device 32. Controller 82 includes a central processing unit (CPU), a read only memory (ROM), a random access memory (RAM), and the like, and is mainly a computer, and is connected to multiple drive circuits 86. Consequently, operations of base material conveyance/holding device 22, component attachment device 24, component supply device 30, and the like are controlled by controller 82. Controller 82 is also connected to image processing device 88. Image processing device 88 processes captured images acquired by mark camera 26 and part camera 140, and controller 82 acquires various types of information from the captured images.

Next, chromatic aberration will be described. There are two types of chromatic aberration such as axial chromatic aberration and magnification chromatic aberration.

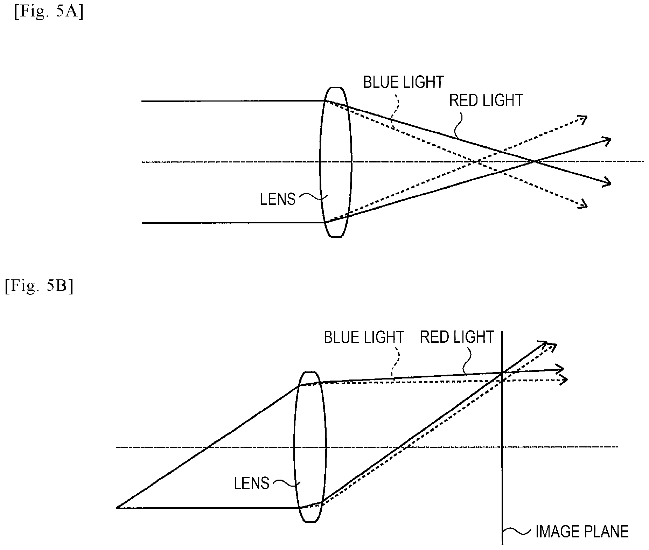

The axial chromatic aberration means a phenomenon in which light beams which are parallel to the optical axis do not form images at one point on the optical axis due to different refractive indexes resulting from different wavelengths. Specifically, as illustrated in Fig. 5(a), an image is formed on the front side in a case of blue light, and on the back side in a case of red light.

On the other hand, the magnification chromatic aberration means a phenomenon in which light beams obliquely incident to the optical axis form images at different positions on an image plane, and thus a color deviation tends to occur more at radially outer circumferential parts of the images. Specifically, as illustrated in Fig. 5(b), even if focal lengths are the same, distances from the center line of the lens are different between the blue light and the red light.

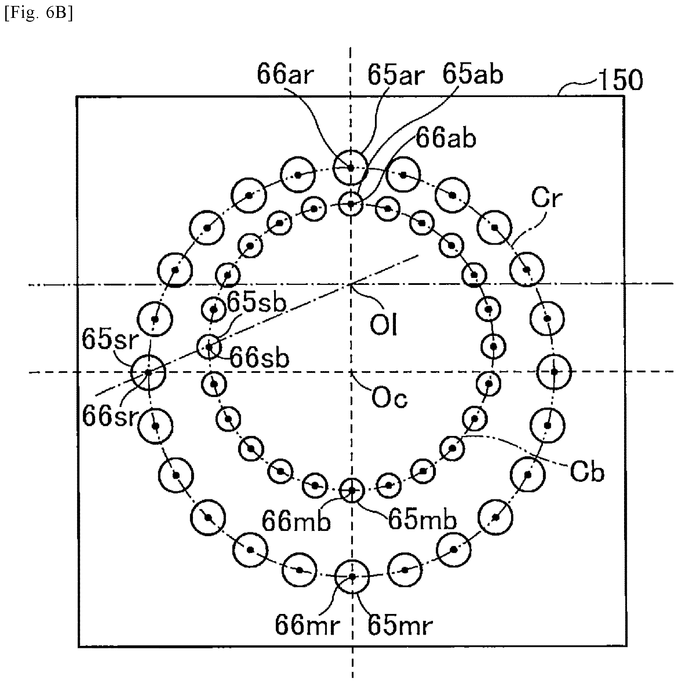

Fig. 6(b) illustrates a captured image obtained by part camera 140 capturing an image of lower end face 61 in Fig. 6(a). The captured image in Fig. 6(b) represents an image obtained by combining an image captured through imaging when the red LED emits light (hereinafter, referred to as a "first captured image") and an image captured through imaging when the blue LED emits light (hereinafter, referred to as a "second captured image").

In Fig. 6(b), circle Cr represents a circle formed by connecting centers of holders 65ar to 65xr included in the first captured image, that is, tips of suction nozzles 66ar to 66xr. On the other hand, circle Cb represents a circle formed by connecting centers of holders 65ab to 65xb included in the second captured image, that is, tips of suction nozzles 66ab to 66xb. The diameter of circle Cr and the diameter of circle Cb are different due to the influence of the magnification chromatic aberration. Since the magnification chromatic aberration occurs toward the lens center, as illustrated in Fig. 6(b), in a case where lens center Ol and camera center Oc deviate with respect to each other, deviation occurs between the center of circle Cr and the center of circle Cb. Therefore, for example, a deviation width between the tip of the thirteenth suction nozzle 66mr in the first captured image and the tip of thirteenth suction nozzle 66mb in the second captured image is larger than a deviation width between the tip of first suction nozzle 66ar in the first captured image and the tip of first suction nozzle 66ab in the second captured image.

Conversely, in a case where lens center Ol coincides with camera center Oc, there is no deviation between the center of circle Cr and the center of circle Cb. However, since lens center Ol is not visible, lens center Ol is not aligned with camera center Oc when part camera 140 is assembled. Therefore, in many cameras, including part camera 140, there is deviation between the lens center and the camera center.

Although the influence of such chromatic aberration can be eliminated by lens design, in the present embodiment, the influence of chromatic aberration is not eliminated by the lens design but is eliminated by calibration.

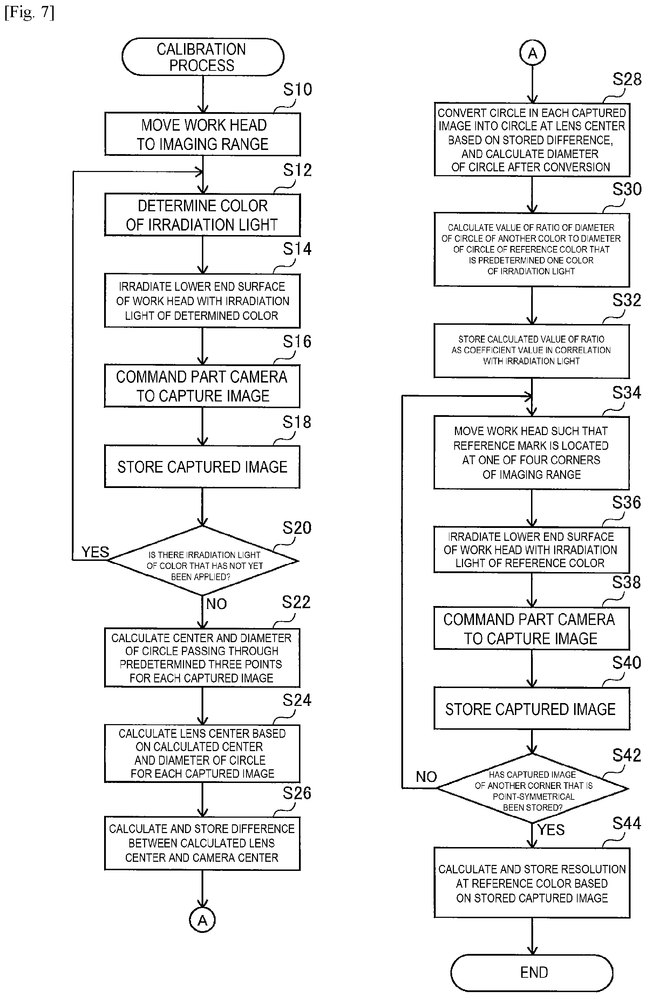

Fig. 7 illustrates a procedure of a calibration process executed by controller 82. Hereinafter, in descriptions of the procedures of each process, a step is denoted by "S".

The calibration process is executed when it is necessary to remove the influence of the chromatic aberration, specifically, when work heads 60 and 62 are replaced with other work heads, or when the influence of the chromatic aberration becomes different due to aging or the like.

When the calibration process is started, first, controller 82 commands work head moving device 64 via drive circuit 86 to move work head 60 to imaging range 150 (refer to Fig. 6(b)) (S10). Although the calibration process is performed not only on work head 60 but also on work head 62, for convenience of description, it is assumed that the calibration process is performed only on work head 60 in the present embodiment.

Next, controller 82 determines a color of irradiation light from lighting section 141 (S12). In the present embodiment, colors of the irradiation light are two colors such as red and blue, but the present invention is not limited to this, and may be three colors in addition to the case where red light and blue light are applied simultaneously, or may be four colors or more as long as lighting section 141 can apply irradiation light of four or more colors.

Next, in step S14, controller 82 commands lighting section 141 to irradiate lower end face 61 of work head 60 with the irradiation light of the determined color.

Next, controller 82 commands part camera 140 to capture an image (S16). In response to this, part camera 140 captures an image of lower end face 61 of work head 60 located in imaging range 150, and outputs the captured image to image processing device 88.

Controller 82 reads the captured image from image processing device 88, and temporarily stores the captured image in the RAM, for example (S18).

Next, in step S20, controller 82 determines whether or not there is irradiation light of a color that has not yet applied. When red light is first applied and blue light is applied next as the irradiation light, since the blue irradiation light has not yet applied, it is determined in the determination in S20 that there is irradiation light of a color that has not yet applied (S20: NO), and controller 82 returns the processing to S12.

Controller 82 executes the processes in S12 to S18 described above on the blue irradiation light. After this process is executed, it is determined in the determination in S20 that there is no irradiation light of a color that has not yet applied (S20: YES), and controller 82 causes the process to proceed to the next S22.

In S22, the center and a diameter of a circle passing through predetermined three points are calculated for each captured image, that is, the first and second captured images. Here, the predetermined three points are, in the present embodiment, for example, points in the first and second captured images, respectively corresponding to the tip of first suction nozzle 66a, the tip of thirteenth suction nozzle 66m, and the tip of nineteenth suction nozzle 66s. The reason why three points are taken is to satisfy the minimum condition that one circle is determined. This is because one circle is not determined by two points, and one circle is determined by four or more points, but the processing time for determining one circle is longer than in the case where three points are taken. However, the three points to be adopted may be any three of the tips of twenty-four suction nozzles 66a to 66x. When coordinates of predetermined three points included in each of the first and second captured images are known, the center and the diameter of each circle passing through the three points can be easily calculated from the coordinates according to a well-known method, and thus a description of the calculation method will be omitted.

Next, controller 82 calculates lens center Ol based on the center and the diameter of each circle calculated in the first and second captured images (S24). Specifically, controller 82 calculates a movement direction and a movement amount of the center of each circle and a reduction amount of the diameter, calculates a position at which the center of the circle moves when the diameter converges to "0", and sets this position as lens center Ol.

Next, controller 82 calculates a difference between calculated lens center Ol and camera center Oc, and temporarily stores the difference in, for example, the RAM (S26).

Next, controller 82 converts each circle calculated in the first and second captured images into each circle at lens center Ol based on the stored difference, and calculates a diameter of each circle after the conversion (S28). The reason why conversion into each circle at lens center Ol in this manner is that, as described above, the magnification chromatic aberration occurs toward lens center Ol, whereas each circle calculated in S22 is a circle at camera center Oc, and the influence of the magnification chromatic aberration cannot be accurately calculated with the circle at camera center Oc.

Specifically, in the calculation process in S28, the stored difference is denoted by (Ax, Ay), coordinates of the respective tips of first, thirteenth, and nineteenth suction nozzles 66ar, 66mr, and 66sr included in the first captured image are denoted by (Rx1, Ry1), (Rx2, Ry2), and (Rx3, Ry3), and coordinates of the respective tips of first, thirteenth, and nineteenth suction nozzles 66ab, 66mb, and 66sb included in the second captured image are denoted (Bx1, By1), (Bx2, By2), and (Bx3, By3). Since these coordinates are coordinates at camera center Oc, controller 82 converts the coordinates into coordinates at lens center Ol. That is, controller 82 calculates coordinates (Rx1-Ax, Ry1-Ay), (Rx2-Ax, Ry2-Ay), and (Rx3-Ax, Ry3-Ay) for the coordinates (Rx1, Ry1), (Rx2, Ry2), and (Rx3, Ry3) in the first captured image, and calculates coordinates (Bx1-Ax, By1-Ay), (Bx2-Ax, By2-Ay), and (Bx3-Ax, By3-Ay) for the coordinates (Bx1, By1), (Bx2, By2), and (Bx3, By3) in the second captured image. Controller 82 determines each circle passing through the three points after the conversion, and calculates a diameter of each circle.

Next, controller 82 calculates, with predetermined one color of the irradiation light as a reference color, a value of a ratio of the diameter of the circle of another color to the diameter of the circle of the reference color (S30). For example, in a case where the reference color is red, controller 82 calculates the diameter of the circle after the conversion from camera center Oc into lens center Ol in the second captured image/the diameter of the circle after the conversion from camera center Oc into lens center Ol in the first captured image.

Next, controller 82 stores the calculated value of the ratio as a coefficient value in correlation with the irradiation light (S32). In the present embodiment, since the value of the ratio is the diameter of the circle after conversion in the second captured image, that is, the captured image with the blue irradiation light/the diameter of the circle after conversion in the first captured image, that is, the captured image with the red irradiation light, the calculated value of the ratio, that is, the coefficient value is stored in correlation with blue. However, since the coefficient value is used when an electronic component (hereinafter abbreviated to "component") is mounted on a circuit base material after the calibration process is completed before the next calibration process is executed, it is preferable to store the coefficient value in a memory in which storage of the coefficient value is maintained even in a case where the supply of power to control device 34 is stopped.

Next, controller 82 commands work head moving device 64 via drive circuit 86 to move work head 60 such that reference mark M (refer to Fig. 6(a)) is located at one of the four corners of imaging range 150 (S34).

Next, controller 82 commands lighting section 141 to irradiate lower end face 61 of work head 60 with the irradiation light of the reference color (S36).

Since the subsequent processes in S38 and S40 are respectively the same as the processes in S16 and S18, descriptions thereof will be omitted.

Controller 82 determines whether or not a captured image of one corner that is point-symmetrical to one corner where reference mark M is located with respect to the center of imaging range 150 in imaging range 150 has been stored (S42). In this determination, in a case where it is determined that captured images of the two corners have not yet been stored (S42: NO), controller 82 returns the process to S34.

Controller 82 locates reference mark M at another corner of imaging range 150 (S34), and then executes the processes in steps S36 to S40. After these processes are executed, in the determination in S42, it is determined that the captured images of the two corners have been stored (S42: YES), and controller 82 causes the process to proceed to the next S44.

In S44, controller 82 calculates and stores a resolution at the reference color based on the stored two captured images. Specifically, controller 82 acquires coordinates of the center of reference mark M for each captured image, and calculates a length of a line segment having each image as an end point. Controller 82 calculates the calculated length of the line segment/the number of pixels included in the line segment, and stores the calculation result as a resolution at the reference color, that is, the resolution at red in the present embodiment. Since the resolution at the reference color is also used when a component is mounted on a circuit base material after the calibration process is completed and before the next calibration process is executed, similarly to the coefficient value, it is preferable to store the resolution in the memory in which storage of the coefficient value is maintained even in a case where the supply of power to control device 34 is stopped.

When the process in S44 is completed, controller 82 finishes the calibration process.

Next, it will be described how to use the coefficient value and the resolution in the reference color stored through the calibration process when a component is mounted on a circuit base material.

When a component is mounted on the circuit base material, as described above, a mounting target component is held by suction nozzle 66, and the held component is imaged by part camera 140. By performing image processing on the captured image obtained by part camera 140, controller 82 recognizes a position of the component with respect to the center of suction nozzle 66 from the image of the component included in the captured image. The position of the center of suction nozzle 66 in the captured image is known.

In theory, the center of suction nozzle 66 coincides with a predetermined pickup position of the component (typically, the center of the component). However, due to deviation or the like in a component supply position, the component is picked up in a state in which the center of suction nozzle 66 and the predetermined pickup position of the component deviate relative to each other. Therefore, controller 82 recognizes a deviation amount between the predetermined pickup position of the component and the center of suction nozzle 66. controller 82 controls drive circuit 86 such that the component is disposed immediately above a designated position of the circuit base material in consideration of the recognized deviation amount. Here, a resolution of the captured image obtained by part camera 140 differs depending on a color of the irradiation light. Specifically, an actual distance corresponding to one pixel differs depending on a color of the irradiation light. Thus, controller 82 converts the recognized deviation amount into an actual distance by using the resolution corresponding to the color of the irradiation light, and controls drive circuit 86.

In a case where the color of the irradiation light is the reference color, controller 82 converts the recognized deviation amount into an actual distance by using the resolution at the reference color. On the other hand, in a case where the color of the irradiation light is different from the reference color, controller 82 converts the recognized deviation amount into an actual distance by using a resolution obtained by multiplying the resolution at the reference color by the coefficient value stored in correlation with the color of the irradiation light.

As described above, component mounter 10 of the present embodiment includes part camera 140, work heads 60 and 62 having suction nozzles 66, X-direction moving device 68 and Y-direction moving device 70 that move work heads 60 and 62 at least in the horizontal direction, lighting section 141 capable of applying light having different wavelengths from multiple light sources toward suction nozzles 66, and controller 82.

Controller 82 has imaging command section 160 that commands part camera 140 to apply light having different wavelengths to suction nozzle 66 to image suction nozzle 66, first calculation section 162 that calculates, based on any one captured image among captured images obtained by imaging command section 160 for respective light beams having different wavelengths, a resolution of the captured image, second calculation section 164 that calculates the lens center of part camera 140 based on the captured images for the respective light beams having different wavelengths, and storage section 166 that stores a difference between the lens center calculated by second calculation section 164 and the camera center of part camera 140 as a unique value of part camera 140.

As described above, in component mounter 10 of the present embodiment, it is possible to correct the chromatic aberration included in a captured image of a component without using another device different from component mounter 10.

Incidentally, in the present embodiment, component mounter 10 is an example of a "work machine". Suction nozzle 66 is an example of a "component holder". Work heads 60 and 62 are examples of "holding heads". X-direction moving device 68, Y-direction moving device 70 and Z-direction moving device 72 are examples of "moving device". Part camera 140 is an example of an "imaging device". Controller 82 is an example of a "control device".

Controller 82 further includes third calculation section 168 that calculates coefficient values for calculating resolutions of captured images other than a captured image used as a resolution calculation basis among the captured images for respective light beams having different wavelengths, based on the unique value stored in storage section 166.

Consequently, since resolutions of the captured images other than the captured image used as a resolution calculation basis are obtained by merely multiplying the coefficient value calculated by the third calculation section 168 by the resolution of the captured image used as a resolution calculation basis, a resolution of a captured image for one light beam having a wavelength may be calculated even if there are multiple captured images for light beams having different wavelengths. Therefore, a calculation process can be simplified.

Controller 82 further includes fourth calculation section 170 that multiplies the coefficient value calculated by third calculation section 168 by the resolution calculated by first calculation section 162 to calculate the resolutions of the captured images other than the captured image used as a resolution calculation basis, and correction section 172 that corrects a corresponding captured image based on the resolutions calculated by first and fourth calculation sections 162 and 170.

Suction nozzle 66 includes three or more suction nozzles 66a to 66x, suction nozzles 66a to 66x are arranged at equal intervals on the outer circumferential part of lower end face 61 of work heads 60 and 62, and second calculation section 164 calculates the lens center of part camera 140 based on at least three suction nozzles 66ar, 66mr, 66sr, 66ab, 66mb, and 66sb among suction nozzles 66ar to 66xr and 66ab to 66xb included in the captured images for light beams having different wavelengths.

Consequently, since the lens center of part camera 140 can be calculated by detecting at least three points for each captured image for respective light beams having different wavelengths, the image processing can be simplified, and the calculation processing can also be simplified.

Second calculation section 164 calculates centers and diameters of circles Cr and Cb passing through each of the tips of at least three suction nozzles 66ar, 66mr, 66sr, 66ab, 66mb, and 66sb for each captured image for respective light beams having different wavelengths, and calculates lens center Ol of part camera 140 based on the calculated centers and diameters of respective circles Cr and Cb.

Third calculation section 168 converts each of the tips of at least three suction nozzles 66ar, 66mr, 66sr, 66ab, 66mb, and 66sb from camera center Oc into lens center Ol based on the unique value stored in storage section 166, calculates a diameter of each circle passing through respective tips of at least three suction nozzles after conversion, and calculates the coefficient value based on the calculated diameter of each circle for each captured image of respective light beams having different wavelengths.

The present invention is not limited to the above embodiment, and various modifications can be made within the scope of the claims.
(1) In the above embodiment, work head 60 employs a work head in which twenty-four holders 65a to 65x are arranged at equal intervals on lower end face 61, but there may be at least three holders 65.
(2) In the above embodiment, the magnification chromatic aberration is corrected based on three tips of the suction nozzles 66a to 66x held by holders 65a to 65x, but the present invention is not limited to this, and the magnification chromatic aberration may be corrected based on, for example, three centers of holders 65a to 65x.
(3) In the above embodiment, the magnification chromatic aberration is mainly corrected as chromatic aberration, but the axial chromatic aberration may also be corrected according to a similar technical idea, that is, by multiplying a correction value of the axial chromatic aberration calculated by using a predetermined one color of irradiation light as a reference color by a coefficient such that the axial chromatic aberration in irradiation light of other colors is also corrected.

### Reference Signs List

10: Component mounter, 60, 62: Work head, 66: Suction nozzle, 68: X-direction moving device, 70: Y-direction moving device, 72: Z-direction moving device, 82: Controller, 140: Part camera, 141: Lighting section, 149: Imaging section

## Claims

1. A work machine (10) comprising:
an imaging device (140);
a holding head (60, 62) having a component holder (66);
a moving device (68, 70, 72) configured to move the holding head in at least a horizontal direction;
a lighting device (144) configured to apply irradiation light having different wavelengths from multiple light sources (145) toward the component holder; and
a control device (82), wherein
the control device includes
an imaging command section (160) configured to command the imaging device to irradiate the component holder with light having different wavelengths to capture an image of the component holder,
a first calculation section (162) configured to calculate, based on any one captured image among captured images obtained by the imaging command section for respective light beams having different wavelengths, a number of pixels included in a line segment as a resolution of the captured image for each respective light beam, wherein a length of the line segment corresponds to the actual distance covered from a camera center of the imaging device to an end point of the captured image,
a second calculation section (164) configured to calculate a lens center of the imaging device based on the captured images for the respective light beams having different wavelengths, and
a storage section (166) configured to store a difference between the lens center calculated by the second calculation section and the camera center of the imaging device as a unique value of the imaging device,
**characterized in that**
the component holder includes three or more component holders,
the three or more component holders are arranged at equal intervals on an outer circumferential part of a lower end face of the holding head, and
the second calculation section is configured to calculate the lens center of the imaging device based on at least three component holders among the three or more component holders included in each of the captured images for the respective light beams having different wavelengths.

2. The work machine according to claim 1, wherein
the control device further includes
a third calculation section (168) configured to calculate a coefficient value for calculating resolutions of captured images other than a captured image used as a resolution calculation basis among the captured images for the respective light beams having different wavelengths, based on the unique value stored in the storage section.

3. The work machine according to claim 2, wherein
the control device further includes
a fourth calculation section (170) configured to calculate the resolutions of the captured images other than the captured image used as the resolution calculation basis by multiplying the resolution calculated by the first calculation section by the coefficient value calculated by the third calculation section, and
a correction section (172) configured to correct a corresponding captured image based on the resolutions calculated by the first and fourth calculation sections.

4. The work machine according to any of claims 1 to 3, wherein
the second calculation section is configured to calculate:
- a center and a diameter of a circle passing through each of tips of the at least three component holders for each of the captured images for the respective light beams having different wavelengths, and
- the lens center of the imaging device based on the calculated center and diameter of each circle.

5. The work machine according to any of claims 2 to 4, wherein
the third calculation section is configured to:
- convert each of tips of the at least three component holders from the camera center into the lens center based on the unique value stored in the storage section for each of the captured images for the respective light beams having different wavelengths,
- calculate a diameter of each circle passing through each of tips of the at least three component holders after conversion, and
- calculate the coefficient value based on the calculated diameter of each circle.

## Patentansprüche

1. Bearbeitungsmaschine (10), die umfasst:
eine Bilderzeugungsvorrichtung (140);
einen Halte-Kopf (60, 62) mit einem Bauteil-Halter (66);
eine Bewegungsvorrichtung (68, 70, 72), die so ausgeführt ist, dass sie den Halte-Kopf in wenigstens einer horizontalen Richtung bewegt;
eine Beleuchtungsvorrichtung (144), die so ausgeführt ist, dass sie Bestrahlungslicht mit unterschiedlichen Wellenlängen von mehreren Lichtquellen (145) auf den Bauteil-Halter zu richtet; sowie
eine Steuerungsvorrichtung (82), wobei
die Steuerungsvorrichtung enthält:
einen Teilabschnitt (160) für Bilderzeugungs-Anweisung, der so ausgeführt ist, dass er die Bilderzeugungsvorrichtung anweist, den Bauteil-Halter mit Licht unterschiedlicher Wellenlängen zu bestrahlen, um ein Bild des Bauteil-Halters aufzunehmen,
einen ersten Berechnungs-Teilabschnitt (162), der so ausgeführt ist, dass er auf Basis eines beliebigen aufgenommenen Bildes von den durch den Teilabschnitt für Bilderzeugungs-Anweisung aufgenommenen Bildern für jeweilige Lichtstrahlen mit unterschiedlichen Wellenlängen eine Anzahl von Pixeln berechnet, die in einem Liniensegment enthalten sind, als eine Auflösung des aufgenommenen Bildes für jeden jeweiligen Lichtstrahl, wobei eine Länge des Liniensegmentes der tatsächlichen von einem Kamera-Mittelpunkt der Bilderzeugungsvorrichtung zu einem Endpunkt des aufgenommenen Bildes zurückgelegten Strecke entspricht,
einen zweiten Berechnungs-Teilabschnitt (164), der so ausgeführt ist, dass er einen Objektiv-Mittelpunkt der Bilderzeugungsvorrichtung auf Basis der aufgenommenen Bilder für die jeweiligen Lichtstrahlen mit unterschiedlichen Wellenlängen berechnet, und
einen Speicherungs-Teilabschnitt (166), der so ausgeführt ist, dass er eine Differenz zwischen dem durch den zweiten Berechnungs-Teilabschnitt berechneten Objektiv-Mittelpunkt und dem Kamera-Mittelpunkt der Bilderzeugungsvorrichtung als einen eindeutig der Bilderzeugungsvorrichtung zugeordneten Wert speichert,
**dadurch gekennzeichnet, dass**
der Bauteil-Halter drei oder mehr Bauteil-Halter einschließt,
die drei oder mehr Bauteil-Halter in gleichen Abständen an einem Außenumfangsteil einer unteren Endfläche des Halte-Kopfes angeordnet sind, und
der zweite Berechnungs-Teilabschnitt so ausgeführt ist, dass er den Objektiv-Mittelpunkt der Bilderzeugungsvorrichtung auf Basis wenigstens dreier Bauteil-Halter von den in jedem der aufgenommenen Bilder für die jeweiligen Lichtstrahlen mit unterschiedlichen Wellenlängen enthaltenen drei oder mehr Bauteil-Haltern berechnet.

2. Bearbeitungsmaschine nach Anspruch 1, wobei
die Steuerungsvorrichtung des Weiteren enthält:
einen dritten Berechnungs-Teilabschnitt (168), der so ausgeführt ist, dass er einen Koeffizienten-Wert zum Berechnen von Auflösungen aufgenommener Bilder mit Ausnahme eines als eine Basis für Berechnung von Auflösung genutzten aufgenommenen Bildes von den aufgenommenen Bildern für die jeweiligen Lichtstrahlen mit unterschiedlichen Wellenlängen auf Basis des in dem Speicherungs-Teilabschnitt gespeicherten eindeutig zugeordneten Wertes berechnet.

3. Bearbeitungsmaschine nach Anspruch 2, wobei
die Steuerungsvorrichtung des Weiteren enthält:
einen vierten Berechnungs-Teilabschnitt (168), der so ausgeführt ist, dass er die Auflösungen der aufgenommenen Bilder mit Ausnahme des als die Basis für Berechnung von Auflösung genutzten aufgenommenen Bildes berechnet, indem er die von dem ersten Berechnungs-Teilabschnitt berechnete Auflösung mit dem von dem dritten Berechnungs-Teilabschnitt berechneten Koeffizienten-Wert multipliziert, sowie
einen Korrektur-Teilabschnitt (172), der so ausgeführt ist, dass er ein entsprechendes aufgenommenes Bild auf Basis der von dem ersten und dem vierten Berechnungs-Teilabschnitt berechneten Auflösungen korrigiert.

4. Bearbeitungsmaschine nach einem der Ansprüche 1 bis 3, wobei
der zweite Berechnungs-Teilabschnitt so ausgeführt ist, dass er berechnet:
- einen Mittelpunkt und einen Durchmesser eines Kreises, der durch jedes von vorderen Enden der wenigstens drei Bauteil-Halter hindurch verläuft, für jedes der aufgenommenen Bilder für die jeweiligen Lichtstrahlen mit unterschiedlichen Wellenlängen, und
- den Objektiv-Mittelpunkt der Bilderzeugungsvorrichtung auf Basis des berechneten Mittelpunktes sowie Durchmessers jedes Kreises.

5. Bearbeitungsmaschine nach einem der Ansprüche 2 bis 4, wobei
der dritte Berechnungs-Teilabschnitt ausgeführt ist zum:
- Umwandeln jedes von vorderen Enden der wenigstens drei Bauteil-Halter von dem Kamera-Mittelpunkt in den Objektiv-Mittelpunkt auf Basis des in dem Speicherungs-Teilabschnitt gespeicherten eindeutig zugeordneten Wertes für jedes der aufgenommenen Bilder für die jeweiligen Lichtstrahlen mit unterschiedlichen Wellenlängen,
- Berechnen eines Durchmessers jedes Kreises, der durch jedes von vorderen Enden der wenigstens drei Bauteil-Halter hindurch verläuft, nach Umwandlung, sowie
- Berechnen des Koeffizienten-Wertes auf Basis des berechneten Durchmessers jedes Kreises.

## Revendications

1. Machine de travail (10) comprenant :
un dispositif d'imagerie (140) ;
une tête de maintien (60, 62) ayant un support de composant (66) ;
un dispositif de déplacement (68, 70, 72) configuré pour déplacer la tête de maintien dans une direction au moins horizontale ;
un dispositif d'éclairage (144) configuré pour appliquer une lumière d'irradiation ayant différentes longueurs d'ondes à partir de plusieurs sources lumineuses (145) vers le support de composant ; et
un dispositif de commande (82), dans lequel
le dispositif de commande inclut
une section de commande d'imagerie (160) configurée pour commander au dispositif d'imagerie d'irradier le support de composant avec une lumière ayant différentes longueurs d'ondes pour capturer une image du support de composant,
une première section de calcul (162) configurée pour calculer, sur la base d'une image capturée parmi les images capturées obtenues par la section de commande d'imagerie pour des faisceaux lumineux respectifs ayant différentes longueurs d'ondes, un nombre de pixels inclus dans un segment de ligne en tant que résolution de l'image capturée pour chaque faisceau lumineux respectif, dans lequel une longueur du segment de ligne correspond à la distance réelle parcourue à partir d'un centre de caméra du dispositif d'imagerie jusqu'à un point final de l'image capturée,
une deuxième section de calcul (164) configurée pour calculer un centre de l'objectif du dispositif d'imagerie sur la base des images capturées pour les faisceaux lumineux respectifs ayant des longueurs d'ondes différentes, et
une section de stockage (166) configurée pour stocker une différence entre le centre de l'objectif calculé par la deuxième section de calcul et le centre de la caméra du dispositif d'imagerie en tant que valeur unique du dispositif d'imagerie,
**caractérisée en ce que**
le support de composant inclut trois supports de composant ou plus,
les trois supports de composants ou plus sont agencés à intervalles égaux sur une partie circonférentielle extérieure d'une face d'extrémité inférieure de la tête de maintien, et
la deuxième section de calcul est configurée pour calculer le centre de l'objectif du dispositif d'imagerie sur la base d'au moins trois supports de composants parmi les trois supports de composants ou plus inclus dans chacune des images capturées pour les faisceaux lumineux respectifs ayant des longueurs d'ondes différentes.

2. Machine de travail selon la revendication 1, dans laquelle
le dispositif de commande inclut en outre
une troisième section de calcul (168) configurée pour calculer une valeur de coefficient pour calculer les résolutions des images capturées autres qu'une image capturée utilisée comme base de calcul de résolution parmi les images capturées pour les faisceaux lumineux respectifs ayant différentes longueurs d'ondes, sur la base de la valeur unique stockée dans la section de stockage.

3. Machine de travail selon la revendication 2, dans laquelle
le dispositif de commande inclut en outre
une quatrième section de calcul (170) configurée pour calculer les résolutions des images capturées autres que l'image capturée utilisée comme base de calcul de la résolution en multipliant la résolution calculée par la première section de calcul par la valeur de coefficient calculée par la troisième section de calcul, et
une section de correction (172) configurée pour corriger une image capturée correspondante sur la base des résolutions calculées par les première et quatrième sections de calcul.

4. Machine de travail selon l'une quelconque des revendications 1 à 3, dans laquelle
la deuxième section de calcul est configurée pour calculer :
- un centre et un diamètre d'un cercle passant par chacune des pointes des au moins trois supports de composants pour chacune des images capturées pour les faisceaux lumineux respectifs ayant des longueurs d'ondes différentes, et
- le centre de l'objectif du dispositif d'imagerie sur la base du centre et du diamètre calculés de chaque cercle.

5. Machine de travail selon l'une quelconque des revendications 2 à 4, dans laquelle
la troisième section de calcul est configurée pour :
- convertir chacune des pointes des au moins trois supports de composants du centre de la caméra dans le centre de l'objectif sur la base de la valeur unique stockée dans la section de stockage pour chacune des images capturées pour les faisceaux lumineux respectifs ayant des longueurs d'ondes différentes,
- calculer un diamètre de chaque cercle passant par chacune des pointes des au moins trois supports de composants après conversion, et
- calculer la valeur du coefficient sur la base du diamètre calculé de chaque cercle.
